# EUROPEAN PATENT SPECIFICATION

(11) **EP 0 885 410 B1**
(45) Date of publication and mention of the grant of the patent: **13.09.2000**
(21) Application number: 97914803.8
(22) Date of filing: 27.02.1997
(51) Int. Cl.: G03F 7/38

(54) **THERMAL TREATMENT PROCESS OF POSITIVE PHOTORESIST COMPOSITION**
THERMISCHES VERARBEITUNGSVERFAHREN VON POSITIVER PHOTORESIST-ZUSAMMENSETZUNG
PROCESSUS DE TRAITEMENT THERMIQUE DE COMPOSITION DE PHOTORESINE POSITIVE

(30) Priority: 07.03.1996 US 13010 P
(43) Date of publication of application: 23.12.1998
(73) Proprietor: Clariant Finance (BVI) Limited, Road Town, Tortola (VG)
(72) Inventor: DAMMEL, Ralph, R., Flemington, NJ 08822 (US); LU, Ping-Hung, Bridgewater, NJ 08807 (US); SPAK, Mark, A., Edison, NJ 08837 (US); ALILE, Oghogho, East Orange, NJ 07018 (US)
(74) Representative: Hütter, Klaus, Dr.
(86) International application number: US9703075
(87) International publication number: WO9733206

(56) References cited:
- EP-A- 0 053 708
- EP-A- 0 249 139
- EP-A- 0 361 907
- EP-A- 0 379 120
- EP-A- 0 379 924
- EP-A- 0 410 794
- EP-A- 0 542 008
- DE-A- 3 243 277
- DE-A- 4 033 294
- US-A- 4 689 289
- ADVANCES IN RESIST TECHNOLOGY AND PROCESSING III, SANTA CLARA, CA, USA, 10-11 MARCH 1986, vol. 631, ISSN 0277-786X, PROCEEDINGS OF THE SPIE - THE INTERNATIONAL SOCIETY FOR OPTICAL ENGINEERING, 1986, USA, pages 222-230, XP002036099 NISTLER J L ET AL: "Reduction of proximity reflective notching on a double metal VLSI process by high temperature post exposure baked"
- ADVANCES IN RESIST TECHNOLOGY AND PROCESSING II, SANTA CLARA, CA, USA, 11-12 MARCH 1985, vol. 539, ISSN 0277-786X, PROCEEDINGS OF THE SPIE - THE INTERNATIONAL SOCIETY FOR OPTICAL ENGINEERING, 1985, USA, pages 299-307, XP002036100 SPAK M A: "High temperature post exposure bake (HTPEB) for AZ 4000 photoresist"
- OPTICAL/LASER MICROLITHOGRAPHY VII, SANTA CLARA, CA, USA, 22-24 FEB. 1995, vol. 2440, ISSN 0277-786X, PROCEEDINGS OF THE SPIE - THE INTERNATIONAL SOCIETY FOR OPTICAL ENGINEERING, 1995, USA, pages 562-581, XP002036101 JOHNSON J R ET AL: "A sub-half micron i-line photolithography process using AZ BARLi"
- MICROELECTRONIC ENGINEERING, vol. 35, 1997, AMSTERDAM NL, pages 137-140, XP002036102 G. ARTHUR: "EFFECT OF TEMPERATURE VARIATIONS IN THE POST-EXPOSURE PROCESSES OF OPTICAL LITHOGRAPHY"
- MICROELECTRONIC ENGINEERING, vol. 35, 1997, AMSTERDAM NL, pages 141-144, XP002036103 E. TEGOU ET AL.: "THERMAL ANALYSIS OF PHOTORESISTS IN AID OF LITHOGRAPHIC PROCESS DEVELOPMENT"

## Description

### Background Of The Invention

In the typical microlithographic process used in the semiconductor industry, the photoresist material is applied to the semiconductor substrate by spin-coating. After the spin-coating step, the resist material, which still contains a large amount of solvent (up to an estimated 30%), is still very soft and tacky. In this state, it would not offer resistance to the developer even in the unexposed parts. It must, therefore, be dried and densified in a thermal treatment step commonly called a softbake or prebake. The softbake can be carried out on a hotplate device or in an air oven. On hotplates, the back side of the substrate carrying the resist layer is brought into contact or close proximity to the hot metal surface of the hotplate for a time of 60 to 90 seconds, most typically 60 seconds, a time which has become a kind of standard in the industry. Typically, oven softbakes use even longer times, e.g., a popular condition is 90°C for 30 minutes.

During spin coating, the resist has become highly viscous and has for practical purposes stopped flowing, as evidenced by its failure to planarize topography on substrates which have it. The film is still far from thermodynamic equilibrium, containing a large amount of free volume which to a good extent is taken up by solvent. During the softbake, the resist is heated above its initial flow point again; it may become a liquid for a short time until loss of solvent and densification cause it to solidify again. This process is accompanied by a reduction in film thickness. For some types of resists, for example single-polymer e-beam resists such as hexafluoroisopropylmethacrylate, the bake temperature can be chosen to be above the glass transition temperature of the polymer. In this case, the film comes close to thermodynamic equilibrium. For the diazonapthoquinone resists most commonly used in the semiconductor industry, however, the maximum bake temperature is limited by the thermal decomposition of the diazonaphthoquinone sensitizer (DNQ). The isothermal decomposition temperatures for DNQs typically used in the industry range from 120°C for trihydroxybenzophenone derivatives to about 130°C for non-benzophenone backbones. Usually much lower temperatures are used because with monochromatic radiation such as typically used in g-or i-line wafer steppers, light moving towards the surface and light reflected from the surface interfere to form a standing wave pattern. If the wafer is developed without an additional bake step between exposure and development (a so-called Post-Exposure Bake, or PEB), this standing wave pattern is quite faithfully reproduced in the resist feature, leading to linewidth variations, resolution degradation and increases in the dose or development time to clear an exposed area. The conventional remedy is to carry out a PEB, during which diffusion effects cause an intermixing of the photoproducts and of the intact DNQ. The standing wave pattern is smeared out by this diffusion process to a degree that it is almost completely unobservable in many practical resist processes.

In order to be able to carry out the diffusion process with sufficient effectiveness, it is typically necessary to carry out the PEB at higher temperatures than the softbake. A typical combination is a softbake of 90°C for 60 seconds, followed by a PEB of 110°C for 60 seconds. Processes in which SB and PEB are carried out at the same temperature are rare, and the inventors know of no practical process for the most common diazanaphthoquinone type resists in which the SB exceeds the PEB. Under the latter conditions, the SB would harden the resist matrix to the extent that the standing wave could not be diffused out, leading to the above-mentioned undesirable phenomena.

These considerations change if the resist substrate is essentially non-reflecting, such as when it is covered with an antireflective coating. With these coatings (either inorganic layers such as titanium nitride (TiN) or organic layers, one example for which is the AZ® BARLi™ coating sold by the AZ Photoresist Products Division of Hoechst Celanese Corp., the substrate reflectivity can be reduced to a few percent of the original one. For TiN, the minimum reflectivity is calculated to be around 3-3.5% at a thickness of about 50 nm (nanometers) (on a silicon substrate); the reflectivity of the organic bottom layers can be reduced to less than one tenth that, which makes the standing wave pattern sufficiently weak that a post exposure bake is no longer required for most applications.

At the elevated temperature of the PEB, the photoproducts of the diazonaphthoquinone are able to diffuse for certain distances, which leads to the smearing-out removal of the standing waves present on reflective substrates. A certain amount of diffusion is thus desirable in this case. At the same time, the diffusion degrades the latent resist image, e.g., in diazanaphthoquinone resists by the decrease in the concentration gradient of the indenecarboxylic acid photoproducts at the boundary between exposed and unexposed areas. On non-reflective substrates such as bottom coats, however, the degradation of the latent image in the photoresist by the diffusion process often outweigh the benefits of the PEB for most applications. Experimental observation also confirms this: on antireflective bottom coats, such as AZ®'s BARLi™ material, the resolution of commercial resists, such as AZ®7800 i-line resist, is enhanced if a PEB is omitted (e.g., from 0.34 to 0.32 µm (micrometers) lines and spaces in a ca. 1 µm (micrometers) resist).

However, even if a bottom antireflective coating is used, one sometimes observes remnants of standing waves with a PEB-free process for resist features at the end of the resolution or defocus range, or in situations where, due to the substrate topography or other factors, the optimum bottom antireflector film thickness cannot be achieved. These remnants limit the achievable resolution, wall angle and linewidth uniformity of the resist feature. The present invention provides a further improvement in photoresist resolution and performance by using a higher than conventional post exposure bake (PEB) temperature (≥130°C) and a very short baking time (≤ 30 seconds) of the resist. This process will in the following be referred to as the "Flash post exposure bake" or "Flash PEB" process. The Flash PEB process significantly improves the photoresist's resolution, process latitude, thermal deformation temperature, resist adhesion and plasma etch resistance.

The resolution improvements observed by use of the Flash PEB process on antireflective coatings are demonstrated in Example 1. Example 2 demonstrates the improvements in thermal stability of developed resist features, and Example 3 the increase in etch resistance.

It should be noted that the full benefits of the Flash PEB are not obtained unless it is carried out over a bottom antireflective coating, such as TiN or AZ® BARLi™ coating. If the antireflective coating is absent, one still obtains the benefit of higher thermal stability, but the resolution capability of the photoresist is slightly degraded compared to that of resist processed with a conventional PEB (Example 4). This process may, however, still be useful if one desires to image only large features, such as predominate, e.g., on a pad or implant mask layer, for which higher thermal and higher etch stability are particularly desirable.

Without wishing to be bound by theory, we believe that the Flash PEB process enhances resist performance because it allows more effective drying and densification of the photoresist than conventional resist processing. In spin coating, the photoresist stops thinning and reaches a non-fluid state which still contains large amounts of solvent. During softbaking, the rise in temperature initially brings the resist back into a fluid state in which solvent can efficiently escape from the resist. However, the resist quickly is brought back into a non-fluid, glassy state as the evaporation of solvent hardens the matrix. Solvent cannot escape efficiently once the resist matrix has been thus hardened. It is well known that even after long temperature treatments, e.g., convection oven bakes for 30 minutes, the resist still contains essentially the same amount of solvent that is found after the much shorter hot plate bakes at the same temperature. We conclude from that that most of the solvent evaporation occurs in the initial period in which the resist is still fluid.

During exposure, a latent image forms in the film which, as pointed out above, may contain standing waves, the removal of which requires a PEB process. During the PEB, the resist matrix is sufficiently softened that photoproduct diffusion occurs; at the same time, some additional solvent evaporation and film densification takes place. This is evidenced by small gains in thermal stability and small reductions in film thickness during the PEB. However, as soon as the wafer has reached the maximum temperature, the matrix hardens again, upon which diffusion slows and solvent evaporation ceases.

During the short time of the Flash PEB process, the resist and wafer do not reach the temperature of the hotplate. Measurements of the wafer temperature show that the wafer is still about 5-10°C below a hotplate temperature of 140°C after 20 seconds. Therefore we believe that the resist re-enters in a fluid state during the Flash PEB process, leading to a more thorough drying of the film which causes the completely unexpected and unforeseen improvement in the thermal stability of the resist. As shown in Example 2, the thermal stability obtained with the Flash PEB process is higher by 20 to 30°C than with a conventional softbake process.

Moreover, we believe that the films obtained by the Flash PEB are closer to thermodynamic equilibrium than the films obtained by the longer conventional bakes at lower temperature. All resist films contain a large amount of free volume after spincoating and baking. This free volume can only be removed if the resist is baked above its glass transition temperature, allowing the polymer strings to relax and form a new, more densely packed order. In a conventional softbake process of 60 seconds or so duration, this can be accomplished for thermally stable resists such as polymethylmethacrylate (PMMA) and hexafluoroisopropylmethacrylate, but not for novolak films because the temperatures necessary would lead to thermal decomposition of the sensitizer, further hardening the matrix by crosslinking effects and causing a deterioration of the imaging properties. We believe that the new Flash PEB process leaves the resist in a state with reduced free volume, and that this reduced free volume allows better dissolution properties leading to the observed resolution enhancement. At the same time, its short duration minimized the detrimental effects of sensitizer decomposition.

The free volume effects mentioned above will be expected to be particularly strong in resists which have high glass transition temperatures, e.g., one such class of resists is that of DUV resists based on t-butoxycarbonyl-protected polyhydroxstyrene, in which the free volume leads to undesirable effects due to the facile diffusion of base contaminants. Another example for such a class is that of diazonaphthoquinone/novolak resists which make use of fractionated resins, i.e., resins in which part or all of the low-MW components typically present in a novolak synthesis by condensation of phenolic compounds and formaldehyde have been removed. There are many ways to achieve a molecular weight dependent fractionation. One which shall be discussed here, in order to illustrate the nature of the material, utilizes a molecular weight dependent miscibility gap of the novolak in a mixture of good and bad solvent. Upon admixture of the bad solvent to a solution of the novolak in the good solvent, two phases separate, although the good and bad solvent may be fully miscible. The lower phase contains the high-MW novolak, with the low-MW materials remaining in the (typically larger) upper phase. By variation of concentrations and ratios of the solvents, it is possible to achieve control over the maximum MW removed and the degree of removal of the low MW fractions. Due to the lack of low-MW fractions, resists based on fractionated novolaks will have higher glass transition temperatures, hence they tend to solidify more quickly during spin coating and conventional softbaking. Improved removal of the free volume and of trapped solvent during the Flash PEB process explains the improvements in thermal stability and etch resistance observed.

In DNQ/novolak resists, fractionation very often causes a large reduction of the resist sensitivity. One therefore often admixes monomeric or low-MW polymeric components to the resist in order to achieve higher sensitivity. Resists of this type will also be expected to benefit from the process of this invention.

Besides the nature of the resin, the nature of the sensitizer, in particular its thermal stability, is also important in considering the effect of high-temperature bakes on the resist performance. In the experience of the inventors, there is a distinct sequence of stability for diazonaphthoquinone (DNQ) esters which is generally observed: 2,1,5-DNQs are more stable than 2,1,4-DNQs; aliphatic esters are less stable than aromatic esters; in aromatic esters, those which have 2 or more DNQ moieties attached to a single phenyl ring in the backbone (such as trihydroxybenzophenones) are less stable than non-benzophenone esters, especially those with only a single DNQ unit per phenyl ring. The highest stabilities are thus observed for 2,1,5-DNQ-sulfonates of backbones containing one or more monohydric phenols. Such compounds are anticipated to be particularly useful in the process of this invention, since their higher thermal stability will minimize undesirable side reactions of the high temperature bakes. The benefits of the Flash PEB process will therefore be greater for resists containing such backbones.

### Summary Of The Invention

What is claimed is a process for preparing a relief image on a substrate of low reflectivity which comprises applying an antireflective coating on said substrate coating a diazoquinone/novolak photoresist on a substrate, exposing the photoresist to actinic light and then a short (flash) post exposure bake step (Flash PEB) the exposure of a photoresist to actinic light. The photoresist is coated on a substrate, and this assembly may have been subjected to a drying bake prior to the exposure to actinic light. The Flash PEB step is carried out by bringing the substrate into contact or close proximity with a heated surface not lower in temperature than 130 °C, for a period of no longer than 30 seconds (5-30 seconds). The temperature of the heated surface is preferentially between 130 to 160°C, most preferentially between 140 to 150°C. The baking time of the resist is preferentially lower than 20 seconds (5-20 seconds), most preferentially between 10 and 20 seconds. The baked process may be carried out on devices such as are customarily used in the semiconductor industry, i.e. hotplates, optionally in the form of a proximity bake in which the distance between substrate and hotplate is regulated by a distance holder device, e.g., balls inserted into the hotplate surface. The baked, emposed photoresist is then treated conventionnally to develop the final image on the substrate.

The process of this invention significantly improves the photoresist's resolution, process latitude, thermal deformation temperature, resist adhesion and plasma etch resistance.

The situation in which the diazonaphthoquinone sensitizer is thermally stable has proven particularly advantageous, since the higher thermal stability further reduces thermal decomposition effects of the sensitzer which otherwise might impair performance. Thermal stability of diazonaphthoquinones is highly correlated to the backbone structure. In particular, backbones which are neither aliphatic compounds nor derivatives of benzophenone often show higher thermal stability, in particular if they are aromatic compounds in which no more than a single hydroxy group is attached to any phenyl ring.

The process of this invention is also perceived to be particularly advantageous for photoresists containing fractionated novolak resins, i.e., resins which have undergone a process in which the low molecular weight components present after synthesis have been partially or completely removed, since the process of this invention provides for a higher degree of densification and the presence of less free volume than can be accomplished with prior art processes. Most particularly, the reduction in free volume may be assisted by a combination of the fractionated resin with monomeric or low-MW speed enhancer compounds. Such compounds are frequently added to such resins in order to enhance the light sensitivity.

### Examples

### Example 1: Resolution Improvement by the Flash PEB on an antireflective substrate

A commercial antireflective material, AZ®BARLi™ antireflective coating, is coated on a silicon wafer and baked at 160°C to yield a uniform coating of 160 nm (nanometers) thickness. A commercial i-line resist, AZ®7800 resist, is then coated and baked for 1 minute at 100°C to yield a resist film of about 0.65 µm (micrometer) thickness. The film is then imaged on a Nikon® 0.63 NA i-line stepper at a variety of doses. The wafer is subjected to a Flash PEB by placing it on a hot plate heated to 150°C for 12 seconds, then developed for 60 seconds in a 2.38% TMAH solution at 23°C. The correct imaging dose is determined by measuring the width of the 0.35 µm (micrometers) line and space features, yielding a 1:1 imaging dose of approx. 190 mJ/cm². At that dose, the finest structures obtained are 0.26 µm (micrometers) equal line and space features. The finest features which remain linear (i.e., within ±10% of the target linewidth) are 0.28 µm (micrometers) equal line and space features.

In comparison, if the above process is carried out with the difference that a softbake of 90°C for 60 seconds and a PEB of 110°C for 90 seconds is carried out instead of the above bake conditions, the resist resolves only 0.28 µm (micrometers) and is linear only to 0.30 µm (micrometers) at an imaging dose of approx. 210 mJ/cm².

### Example 2: Thermal Stability Improvement by the Flash PEB

The Flash PEB process of Example 1 is carried out on the BARLi™-covered substrate of Example 1. A second sample is processed identically, only the Flash PEB temperature is 150°C. A third, comparison wafer is processed with a 90°C, 60 seconds hot plate softbake and a 110°C, 90 seconds conventional hotplate PEB. For both the Flash PEB and the comparison wafers, the thermal flow resistance of the resist is determined as described in the paragraph below.

The mask used for the exposure contains large square pad (500 x 500 µm (micrometers)) features. The wafer which contains a number of stepfields with the desired structures is broken into pieces. Each wafer fragment, which contains at least one pad structure, is individually heated at one temperature on a hotplate for 2 minutes, starting at a hotplate temperature of 100°C for the first fragment and going to 150°C for the last fragment in increments of 5°C. The edges of the pad features are then inspected by SEM (scanning electron microscope), and it is determined at which temperature the resist pad has deformed.

For the comparative sample processed with the conventional bake, the pads are seen to deform at a temperature of 115°C. For the Flash PEB at 150°C, the deformation temperature is 135°C, and for the 160°C bake, it is 140°C.

### Example 3: Increase in Dry Etch Resistance

Two wafers are prepared with AZ®7800 resist on a 150 nm (nanometers) thick BARLi™ coating on silicon oxide wafers. The first wafer is prepared with a bake at 90°C and a PEB at 110°C for 90 seconds, resulting in a film thickness of approx. 1.05 µm (micrometers), the second wafer is prepared with a 100°C/60 seconds softbake and the Flash PEB process (160°C/12 seconds). The film thickness of the second wafer is 0.5 µm (micrometer). After imaging, both wafers are subjected to a dry etch process involving a CHF₃/oxygen mixture until the silicon oxide has been etched through. The 0.40 µm (micrometer) features are then inspected by SEM. It is found that the 1 µm (micrometer) resist which has been subjected to the conventional bake has lost about 0.6-0.7 µm (micrometer) of film thickness, while the Flash PEB film has only lost 0.15-0.2 µm (micrometer). The Flash PEB film is thus found to have higher film thickness than the conventional film, although the initial film thickness was only half of the latter's.

### Comparative Example : Flash PEB in the Absence of an Antireflective Coating

The experiment of Example 1 is repeated with the difference that no antireflective coating is applied to the silicon wafers; also, only one Flash PEB wafer is generated at conditions of 150°C/12 seconds. A 0.54 NA stepper was used for imaging. It is found that the linear resolution of the resist (as defined in Example 1) is 0.34 µm (micrometers) for the conventional process at an imaging dose of 180 mJ/cm², and that 0.32 µm (micrometers) features can be resolved at a higher dose. For the Flash PEB sample, linear resolution has dropped to 0.38 µm (micrometer) for a 1:1 imaging dose of 245 mJ/cm², while the 0.36 µm (micrometer) features can be resolved at a higher dose (although with a poor wall angle). While the resolution is thus found to be degraded in the absence of an antireflective coating, a test of the thermal stability of the Flash PEB sample again shows the large pads to be deformed only at 140°C.

### Example 4: Resolution and DOF Improvement with the Flash PEB on a 0.57 NA i-line stepper

Wafers were coated with AZ® BARLi™ solution to produce a film of approximately 150 nm (nanometer) thickness. The BARLi™ film was then baked at 170°C for 60 seconds on a hot plate. AZ®7800 resist was spun on at 3,000 rpm, the wafers were baked at 110°C for 60 seconds, and exposed on a Nikon® 0.57 NA stepper using an array of focus settings and exposure energy. Wafers were baked on a Dai Nippon Screen hot plate (with 150 µm (micrometers) proximity spacers inserted) at 150°C for 20 seconds. Images were developed first forming a puddle of developer on the wafer, and then allowing for the develop process to continue for a total of 60 seconds. After a water rinse of developed image, the resulting images were inspected by SEM measurement of cleaved structures. We found that the resolution was improved by 0.04 µm (micrometers), and that the depth of focus near the limits of resolution was also improved by 0.4 µm (micrometers) versus a control sample processed under identical conditions but with a 90°C/60 seconds softbake and a 110°C/90 seconds PEB. Specifically, the resolution of the control wafer was approx. 0.30 µm (micrometer), and the resolution of the experimental wafer was 0.26 µm (micrometer). The depth of focus of the control for 0.30 µm (micrometer) equal line and space features was approx. 0.4 µm (micrometer), and that of the flash PEB experiment was 0.8 µm (micrometer).

## Claims

1. A process for preparing a relief image on a substrate of low reflectivity which comprises applying an antireflective coating on said substrate, coating a diazonaphthoquinone/novolak photoresist on said substrate, exposing the photoresist to actinic light, baking the photoresist coating, and treating the coated substrated to develop the image on said substrate, said bake step being carried out by bringing the substrate into contact or close proximity with a heated surface not lower in temperature than 130°C, for a period of no longer than 30 seconds.

2. The process of Claim 1, in which the temperature of the heated surface is between 130 to 160°C.

3. The process of Claim 1, in which the temperature of the heated surface is between 140 to 150°C.

4. The process of Claim 1, in which the baking time is lower than 21 seconds.

5. The process of Claim 1, in which the baking time is between 10 and 20 seconds.

6. The process of Claim 1, in which the diazonaphthoquinone sensitizer has a backbone which is an aromatic compound but not a derivative of benzophenone.

7. The process of Claim 6, in which the aromatic compound has not more than one hydroxy group on any phenyl ring.

8. The process of Claim 1, wherein the photoresist contains the novolak resin and the novolak resin has undergone a process in which the low molecular weight components thereof have been partially or completely removed.

9. The process of Claim 8, in which the photoresist contains a monomeric compound or low molecular weight compound which increases the light sensitivity.

10. The process of Claim 1, in which the antireflective coating is an inorganic absorbing or transparent material, where the transparent material is preferentially silicon oxide, and the absorbing material is preferentially silicon or titanium nitride.

11. The process of Claim 1, where the antireflective coating is an organic material which is removed in an imagewise way either in the process of developing the photoresist, or in a dry etch process.

12. The process of Claim 11, in which the antireflective layer is a dyed material with an absorptivity greater than 2 µm⁻¹, most preferentially with an absorptivity of greater than 8 µm⁻¹.

## Patentansprüche

1. Verfahren zur Herstellung einer strukturierten Abbildung auf einem Träger mit geringem Reflexionsvermögen, wobei eine reflexionsvermindernde Beschichtung auf den genannten Träger aufgebracht, der Träger mit einem Diazonaphthochinon/Novolak-Photoresist beschichtet, das Photoresist mit aktinischem Licht belichtet, die Photoresistbeschichtung getrocknet und der beschichtete Träger zur Entwicklung der Abbildung auf dem genannten Träger behandelt wird, und wobei der Träger zur Trocknung mit einer beheizten Fläche, die eine Temperatur von mindestens 130°C aufweist, höchstens 30 Sekunden lang in Berührung oder in unmittelbare Nähe einer solchen Fläche gebracht wird.

2. Verfahren gemäß Anspruch 1, wobei die Temperatur der beheizten Fläche zwischen 130°C und 160°C liegt.

3. Verfahren gemäß Anspruch 1, wobei die Temperatur der beheizten Fläche zwischen 140°C und 150°C liegt.

4. Verfahren gemäß Anspruch 1, wobei die Trocknungszeit weniger als 21 Sekunden beträgt.

5. Verfahren gemäß Anspruch 1, wobei die Trocknungszeit zwischen 10 und 20 Sekunden liegt.

6. Verfahren gemäß Anspruch 1, wobei das Gerüst des Diazonaphthochinon-Sensibilisators eine aromatische Verbindung, nicht aber ein Benzophenonderivat ist.

7. Verfahren gemäß Anspruch 6, wobei die aromatische Verbindung an jedem Phenylring höchstens eine Hydroxylgruppe besitzt.

8. Verfahren gemäß Anspruch 1, wobei das Photoresist ein Novolakharz enthält, und das Novolakharz einem Verfahren unterzogen wurde, bei dem seine niedermolekularen Bestandteile teilweise oder vollständig entfernt wurden.

9. Verfahren gemäß Anspruch 8, wobei das Photoresist eine monomere oder eine niedermolekulare Verbindung enthält, welche die Lichtempfindlichkeit erhöht.

10. Verfahren gemäß Anspruch 1, wobei die reflexionsvermindernde Beschichtung ein anorganisches, absorbierendes oder transparentes Material ist und wobei es sich bei dem transparenten Material bevorzugt um Siliciumoxid und bei dem absorbierenden Material bevorzugt um Silicium- oder Titaniumnitrid handelt.

11. Verfahren gemäß Anspruch 1, wobei die reflexionsvermindernde Beschichtung ein organisches Material ist, das bei der Entwicklung des Photoresists oder in einem Trockenätzverfahren abbildungsgemäß entfernt wird.

12. Verfahren gemäß Anspruch 11, wobei es sich bei der reflexionsvermindernden Schicht um gefärbtes Material mit einem Absorptionsvermögen über 2 µm⁻¹, am meisten bevorzugt mit einem Absorptionsvermögen über 8 µm⁻¹ handelt.

## Revendications

1. Procédé de préparation d'une image en relief sur un substrat de faible réflectivité qui comprend l'application d'un revêtement antiréfléchissant sur ledit substrat, le dépôt d'un photorésist diazonaphtoquinone/novolaque sur ledit substrat, l'exposition du photorésist à une lumière actinique, la cuisson du revêtement de photorésist et le traitement du substrat revêtu pour développer l'image sur ledit substrat, ladite étape de cuisson étant réalisée en amenant le substrat en contact avec ou à proximité immédiate d'une surface chauffée ayant une température non inférieure à 130°C, pendant une période n'excédant pas 30 secondes.

2. Procédé selon la revendication 1, dans lequel la température de la surface chauffée se trouve entre 130°C et 160°C.

3. Procédé selon la revendication 1, dans lequel la température de la surface chauffée se trouve entre 140°C et 150°C.

4. Procédé selon la revendication 1, dans lequel la durée de cuisson est inférieure à 21 secondes.

5. Procédé selon la revendication 1, dans lequel la durée de cuisson se trouve entre 10 et 20 secondes.

6. Procédé selon la revendication 1, dans lequel le sensibilisateur diazonaphtoquinone possède un squelette qui est un composé aromatique mais pas un dérivé de benzophénone.

7. Procédé selon la revendication 6, dans lequel le composé aromatique ne possède pas plus d'un groupe hydroxy sur n'importe quel cycle phényle.

8. Procédé selon la revendication 1, dans lequel le photorésist contient la résine novolaque et la résine novolaque a subi un traitement dans lequel on y a éliminé tout ou partie des composants de faible masse moléculaire.

9. Procédé selon la revendication 8, dans lequel le photorésist contient un composé monomère ou un composé de faible masse moléculaire qui augmente la sensibilité à la lumière.

10. Procédé selon la revendication 1, dans lequel le revêtement antiréfléchissant est une matière inorganique absorbante ou transparente, où la matière transparente est de préférence de l'oxyde de silicium, et la matière absorbante est de préférence du nitrure de silicium ou de titane.

11. Procédé selon la revendication 1, dans lequel le revêtement antiréfléchissant est une matière organique que l'on élimine selon une image soit dans le procédé de développement du photorésist, soit dans un procédé de gravure sèche.

12. Procédé selon la revendication 11, dans lequel la couche antiréfléchissante est une matière colorante avec une absorptivité supérieure à 2 µm⁻¹, de manière tout particulièrement préférée avec une absorptivité supérieure à 8 µm⁻¹.
